(19) Europäisches Patentamt
European Patent Office
Office européen des brevets

(11) Publication number: 0 041 662
B1

(12) # EUROPEAN PATENT SPECIFICATION

(45) Date of publication of patent specification: 11.04.84

(51) Int. Cl.$^3$: H 01 L 23/30, C 08 G 59/40, C 08 G 59/68

(21) Application number: 81104126.8

(22) Date of filing: 29.05.81

(54) **Resin encapsulation type semiconductor device.**

(30) Priority: 05.06.80 JP 74943/80
18.06.80 JP 81344/80
20.06.80 JP 82708/80
18.03.81 JP 37830/81
18.03.81 JP 37831/81
08.05.81 JP 68374/81

(43) Date of publication of application:
16.12.81 Bulletin 81/50

(45) Publication of the grant of the patent:
11.04.84 Bulletin 84/15

(84) Designated Contracting States:
CH DE FR GB LI NL

(56) References cited:
DE - A - 2 841 751

Chemical Abstracts, vol. 83, 1975 Columbus, Ohio, USA M. KITAMURA et al. "Resin composition for semi-conductor shielding" page 66, column 1, abstract no. 11754p

Chemical Abstracts, vol. 84, 1976 Columbus, Ohio, USA M. KITAMURA et al. "Moisture-resistant epoxy resin compositions for resin-molded semiconductor devices" page 460, columns 1,2, abstract no. 11505d

(73) Proprietor: TOKYO SHIBAURA DENKI KABUSHIKI KAISHA
72, Horikawa-cho Saiwai-ku
Kawasaki-shi Kanagawa-ken 210 (JP)

(72) Inventor: Ikeya, Hirotoshi
2-1-171, Oppamahoncho
Yokosuka-shi, Kanagawa-ken (JP)
Inventor: Suzuki, Hirotoshi
2-27-22, Hujizuku, Kohoku-ku
Yokohama-shi, Kanagawa-ken (JP)
Inventor: Oguni, Takayuki
2364, Hiyoshihoncho, Kohoku-ku
Yokohama-shi, Kanagawa-ken (JP)
Inventor: Matsumoto, Kazutaka
256-6 Sanmaicho, Kanagawa-ku
Yokohama-shi, Kanagawa-ken (JP)
Inventor: Hatanaka, Akiko
2-19-18, Teraya, Tsurumi-ku
Yokohama-shi, Kanagawa-ken (JP)
Inventor: Wada, Moriyasu
1-7-9, Yurigaoka, Ninomiya-cho
Kanagawa-ken (JP)

(74) Representative: Hansen, Bernd, Dr.rer.nat. et al.
Hoffmann, Eitle & Partner Patentanwälte
Arabellastrasse 4
D-8000 München 81 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Resin encapsulation type semiconductor device

This invention relates to a resin encapsulation type semiconductor device, particularly to a semiconductor device encapsulated within an epoxy resin composition comprising an epoxy resin, a novolac resin curing agent and an organic phosphine compound.

Epoxy resins have widely been used as highly reliable electrical insulating materials for their excellent electrical properties, mechanical properties and humidity resistance for encapsulation or impregnation of semiconductor devices, electronic parts as well as electrical parts. In particular, most semiconductor devices, except for a very small part thereof, including integrated circuits. large scale integrated circuits, transistors and diodes are encapsulated using epoxy resin compositions for low pressure molding. The conventional epoxy resin compositions for electrical insulating materials have been most generally used by curing an epoxy resin with a curing agent such as a polyamine, an acid anhydride or a phenol resin together with a curing accelerator such as a tertiary amine or an imidazole. Particularly, in the field of encapsulation of semiconductor devices, there has been used an epoxy resin composition comprising an epoxy resin, a novolac resin curing agent, and an imidazole curing accelerator, which is the most excellent in various respects such as humidity resistance, reliability and moldability, as disclosed in U.S. Patent 3,493,630. The semiconductor device encapsulated within such an epoxy resin composition can advantageously be produced at low cost and on a large scale, as compared with those encapsulated within metals or ceramics. On the other hand, it was inferior in humidity resistance and electrical properties at high temperatures.

From Chemical Abstracts, Vol. 84, No. 11505d there is known an epoxy resin composition for encapsulating semiconductor devices using as a hardening promoting agent a phosphonium salt. This composition, however, does not possess optimal properties with respect to high speed moldability and reliability (moisture resistance).

An encapsulated semiconductor device may sometimes be used or stored under an atmosphere of high temperature and/or high humidity. When an epoxy resin encapsulation type semiconductor device is used at a high temperature under a high humidity, electrical insulation of the semiconductor device may be lowered to lower its performance such as increase of leak current or cause corrosion of aluminium electrodes or wiring, sometimes leading to failure of break down of wiring. Also, when it is used at a high temperature, there may be caused lowering of electrical properties of encapsulating resin such as volume resistivity, which also resulted in increase of leak current. In particular, semiconductor elements having a highly sensitive MOS structure on the surface or having a PN junction on which reverse bias is applied, suffered frequently from such inconveniences as increase of leak current through channeling.

The inferior humidity resistance of an epoxy resin encapsulation type semiconductor device may be due to hygroscopicity or water permeability possessed by a cured epoxy resin on one hand, while it may also be due to hydrolyzable chlorine or ionic impurities contained in cured resin composition on the other. The latter hydrolyzable chlorine and ionic impurities are inevitably remained because of the manufacturing technique employed. When moisture permeates into encapsulating resin, it may be associated with chlorine ions or other ionic impurities, whereby insulating property of the device may be lowered or corrosion of electrodes may be caused.

On the other hand, decrease of electrical properties at higher temperatures may be considered to be due to activated thermal motion of ionic impurities or polar substances contained in minute amounts in encapsulating resins. Particularly, when a voltage is applied on a semiconductor device, motion of ionic impurities or polar substances will be activated by the influence of electric field, whereby marked lowering in electrical properties may locally be caused.

Especially under hot and humid conditions, there may occur complex reactions between humidity, ionic impurities, etc. and the action of the electric field, to thereby damage characteristics of semiconductor devices, deteriorate the device and shorten its life.

In order to improve humidity resistance of an epoxy resin encapsulation type semiconductor device or to improve electrical characteristics thereof at higher temperatures, one can consider that hydrolyzable chlorine or ionic impurities should be removed. But it is practically impossible to remove these impurities completely for the reasons mentioned above.

The evaluation of humidity resistance of a resin encapsulation type semiconductor device, there may be employed a method such as the pressure cooker test (PCT) in which a device is exposed to a saturated water vapor at 85°C or 120°C for examination of the extent of deterioration of aluminum wiring through corrosion or the bias-pressure cooker test (bias-PCT) in which a device on which voltage is applied is exposed to a hot saturated water vapor. On the other hand, for evaluation of electrical characteristics at high temperatures, there is generally employed so called Bias-Temperature test (BT test) in which the quantity of leak current is examined by application of a bias voltage at a temperature from 80°C to 150°C.

The principal object of the present invention is to provide an epoxy resin encapsulation type semiconductor device having improved humidity resistance and high temperature electrical characteristics and being high in reliability.

Another object of the present invention is to provide a resin encapsulation type semiconductor

device encapsulated within a cured epoxy resin which is itself excellent in high temperature electrical characteristics (e.g. volume resistivity).

Still another object of the present invention is to provide a resin encapsulation type semiconductor device having prolonged life due to high resistance to higher temperatures and humidity.

Other objects of the present invention will be apparent from the following description as well as the Examples.

The present invention provides a resin encapsulation type semiconductor device comprising a semiconductor device encapsulated within a cured epoxy resin composition, being characterized in that said epoxy resin composition comprises an epoxy resin, a novolac resin containing phenolic hydroxyl groups at a ratio of about 0.5 to about 1.5 relative to the epoxy groups possessed by said epoxy resin, and 0.001 to 20 parts by weight of an organic phosphine compound per 100 parts by weight of the resin component consisting of said epoxy resin and said novolac resin.

The resin encapsulation type semiconductor device of the present invention is excellent in humidity resistance and high temperature electrical properties. When it is used or stored at high temperatures under high humidity, it is difficultly deteriorated and has advantages of longer life and higher reliability than the prior art products.

The epoxy resin to be used in the present invention is not particularly limited, but any resin known in the art can be employed. Typical epoxy resins are those having two or more epoxy groups per one molecule, including glycidyl ether type epoxy resins such as a bisphenol A type epoxy resin, a phenol novolac type epoxy resin, a cresol novolac type epoxy resin, etc., glycidyl ester type epoxy resins, glycidyl amine type epoxy resins, linear aliphatic epoxy resins, alicyclic epoxy resins, heterocyclic type epoxy resins, halogen-containing epoxy resins, and so on. These epoxy resins may be employed either as single species or a mixture of two or more species. These epoxy resins may also desirably contain a chlorine ion of less than 10 ppm and a hydrolyzable chlorine of less than 0.1% by weight.

Among the epoxy resins as mentioned above, is most preferred a glycidyl ether type epoxy resin. Above all, most excellent characteristics can be obtained when there is employed a novolac type epoxy resin having an epoxy equivalent of 170 to 300. Such a novolac type epoxy resin may be exemplified by a phenol novolac type epoxy resin, a cresol novolac type epoxy resin, etc. which may be used either singly or in mixtures.

In carrying out low pressure transfer molding, an epoxy resin may preferably have a softening point of 60° to 120°C.

When a halogen-containing epoxy resin is added as an epoxy resin component in a small amount in the composition, the resultant composition can be improved in flame retardant property. It is also possible to impart flexibility to the composition by adding a linear aliphatic epoxy resin thereto.

The novolac resin to be used in the present invention functions as a curing agent and may include, for example, a phenol novolac resin, a cresol novolac resin, a tert-butyl phenol novolac resin, a nonylphenol novolac resin and the like. These novolac resins may have a softening point desirably of 60° to 120°C for performing low pressure transfer molding. It is also desirable that content of a water-soluble component at normal temperature should be 3% by weight or less. When an excessive amount of water-soluble components is contained in the composition, the resultant cured resin will be lowered in electrical properties.

The amount of the novolac resin to be formulated in the composition is required to be in the range from about 0.5 to about 1.5 in terms of the ratio of the phenolic hydroxyl groups possessed by the novolac resin to the epoxy groups possessed by the epoxy resin (number of hydroxyl groups/number of epoxy groups). Above all, when the epoxy groups exceed the phenolic hydroxyl groups in number, namely when the above ratio is 0.5 or more and less than 1, there can be obtained a composition excellent in both humidity resistance and high temperature electrical characteristics. The best characteristics can be obtained when said ratio is in the range from 0.77 to 0.95.

As the organic phosphine compound to be used in the present invention, there may be mentioned a compound represented by the general formula [I]:

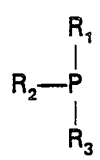

[I]

which may include a tertiary phosphine compound wherein all of $R_1$ to $R_3$ are organic groups, a secondary phosphine compound wherein only $R_3$ is a hydrogen atom and $R_1$ and $R_2$ are organic groups, and a primary phosphine compound wherein both $R_2$ and $R_3$ are hydrogen atoms and $R_1$ is an organic group.

As the organic groups, there may be mentioned alkyl groups such as methyl, butyl, octyl, hexadecyl and the like; cycloalkyl groups such as cyclohexyl, cyclopentyl, cyclopropyl and the like; aryl groups such as phenyl, o-chlorophenyl, p-chlorophenyl, methoxyphenyl, pentachlorophenyl, m-tolyl, p-tolyl, naphthyl and the like; aralkyl groups such as benzyl, phenylethyl and the like; and organic groups

having organic phosphino groups such as organic phosphinoalkyl, e.g., phenylphosphinomethyl, diphenylphosphinomethyl, phenylphosphinoethyl, diphenylphosphinoethyl, diphenylphosphinobutyl, diphenylphosphinodecyl, etc., and the like. For example, the primary phosphine compound may include phenylphosphine, octylphosphine, hexadecylphosphine and others; the secondary phosphine compound may include diphenyl phosphine, dioctyl phosphine, di(2-chlorophenyl)phosphine, di(methoxyphenyl)phosphine, di(pentachlorophenyl)phosphine, butylphenylphosphine, bis(phenylphosphino)ethane and others; and the tertiary organic phosphine compound including, for example, tricyclohexylphosphine, tributylphosphine, methyldiphenylphosphine, dibutylphenylphosphine, diphenylbutylphosphine. There may be mentioned bis(diphenylphosphino)alkanes, of which alkane moiety having 1 to 20 carbon atoms, such as 1,2-bis(diphenylphosphino)ethane, bis(diphenylphosphino)methane, etc. The organic tertiary phosphine also includes triarylphosphines such as triphenylphosphine, tri(p-methoxyphenyl)phosphine, tri(m-tolyl)phosphine, tri(p-tolyl)phosphine, trinaphthylphosphine, tri(p-chlorophenyl)phosphine, and so on.

Among the organic phosphine compounds as set forth above, most excellent characteristics can be obtained when there is employed an arylphosphine such as a triarylphosphine, a diarylphosphine and a bis(diarylphosphino)alkane(alkane moiety having 1 to 20 carbon atoms). In particular, triphenylphosphine, 1,2-bis(diphenylphosphino)ethane and bis(diphenylphosphino)methane may preferably be used.

It is essentially required to add an organic phosphine compound in an amount of 0.001 to 20 parts by weight, preferably 0.01 to 5 parts by weight, based on 100 parts by weight of the resin component (epoxy resin and novolac resin).

Having thus described about the essential components in the epoxy resin composition to be used for the resin encapsulation type semiconductor device according to the present invention, it should also be noted that there may also optionally be added in the composition conventional fillers or various additives known in the art.

According to a preferred embodiment of the present invention, the epoxy resin composition further contains an organic silicon compound having silanolic hydroxyl groups in a proportion of 0.05 to 10% by weight, more preferably 0.1 to 3% by weight, based on the weight of the resin component (epoxy resin and novolac resin) formulated therein. Said organic silicon compound is an organosilane or organopolysiloxane compound having at least one silanolic hydroxyl group ($\equiv Si-OH$ type hydroxyl group), organic group being at least one selected from the group consisting of alkyl groups, aryl groups, vinyl group, aralkyl groups, allyl group and alkoxy groups. A mixture of two or more of said organic silicon compounds may also be used. Among them, particularly preferred are organosiloxane compounds having two or more silanolic hydroxyl groups in one molecule such as methylphenyl polysiloxane compounds and methylpolysiloxane compounds. Typical examples are silane compounds such as $(CH_3)_3SiOH$, $C_6H_5(C_2H_5)Si(OH)_2$ or $(C_6H_5)_2Si(OH)_2$ and linear, cyclic or polycyclic organopolysiloxane compounds (e.g. SH 6018, trade name, produced by Toray Silicone Co., Ltd.).

By formulation of such an organic silicon compound into the composition, bias-PCT characteristic as well as high temperature electrical characteristics can further be improved. When an organic silicon compound is incorporated in the composition in an amount less than 0.05 part by weight based on 100 parts by weight of the resin component, no such effect can be observed. On the contrary, with an amount exceeding 10 parts by weight, these characteristics are rather unfavorably deteriorated. When an organic silicon compound is incorporated in the composition according to this embodiment, it is preferred that the organic phosphine should be added in an amount controlled within the range from 0.01 to 20 parts by weight based on 100 parts by weight of the resin component (epoxy resin and novolac resin).

The following advantages can also be obtained according to this embodiment containing an organic silicon compounds. When a semiconductor device is encapsulated using an epoxy resin composition of prior art according to the transfer molding method, there have been encountered various inconveniences such as production of burrs, poor mold release property of the molded product from a mold, damaged appearance caused by stains such as of mold release agents remained on the surface of the molded product and easy peel-off due to poor adhesion of marking ink. These disadvantageous defects can be overcome according to the above embodiment, whereby manufacturing operations can greatly be improved.

According to another preferred embodiment of the present invention, a metal chelate compound is incorporated in the epoxy resin composition to further improve PCT characteristics. As a center metal forming the metal chelate compound to be used in the present invention, there may be mentioned, for example, aluminum, barium, calcium, cadmium, cobalt, chromium copper, iron, potassium, magnesium, manganese, sodium, nickel, lead, palladium, rhodium, titanium, vandium, zinc, zirconium, etc. As a ligand, there may be mentioned acetylacetone, ethylacetoacetate, glycine, salicylaldehyde, 8-oxyquinoline, ethylenediamine, triethylenetetramine, ethylenediaminetetraacetate, salicyclic acid, oxalic acid, dimethylglyoximine, dipyridl, phenanthroline, etc. Typical examples of metal chelate compounds may include tris(acetylacetonato)aluminium, bis(dimethylglyoximato)nickel, ethylenediaminetetraacetatocobalt, tetrakis(acetylacetonato)zirconium, diglycinatopalladium, disalicylaldehydecopper, tris(ethylacetoacetato)aluminum, etc.

Such a metal chelate compound should be incorporated in the epoxy resin composition in the following manner. While controlling the amount of an organic phosphine compound in the range from 0.01 to 20% by weight based on the resin components, a metal chelate compound should be added in an amount of 1 to 100% by weight, preferably 3 to 50% by weight, based on the weight of said organic phosphine compound. With an amount of a metal chelate compound less than 1% by weight of an organic phosphine compound, no appreciable improvement of PCT characteristic can be effected. On the contrary, an amount in excess of 100% by weight will rather cause deterioration of the characteristic.

It is of course another embodiment of the present invention to incorporate both of the organic silicon compound as mentioned previously and the metal chelate compound, whereby both effects of the organic silicon compound and the metal chelate compound can be obtained.

In the following, description is made about other components which can optionally be added according to conventional formulations.

The composition of the present invention containing no inorganic filler may be used for encapsulation of semiconductor devices such as integrated circuits, large scale integrated circuits, transistors and diodes according to the method such as cast molding or coating. When an inorganic filler is added in the composition, there can be obtained an epoxy resin composition improved in processability. In particular, when it is used as a molding compound, there is a conspicuous effect for improvement of thermal-mechanical characteristics.

Typical examples of inorganic fillers may include quartz glass powders, crystalline silica powders, glass fibers, talc, alumina powders, calcium silicate powders, calcium carbonate powders, barium sulfate powders and magnesia powders and so on. Among them quartz glass powders and crystalline silica powders are most preferred. The proportion of these inorganic fillers, which may differ on uses, resin components (epoxy resin and curing agent for epoxy resin) as well as the inorganic fillers employed, may be sufficiently about 150 to 400 parts by weight per 100 parts of the resin components when used in, for example, transfer molding method. When the composition is to be used for transfer molding method, it is possible to prepare a molding compound with good characteristics by selection of inorganic fillers having a suitable particle size distribution.

A composition containing inorganic fillers is suitable for encapsulation of semiconductor devices such as integrated circuits, large scale integrated circuits, transistors and diodes according to the transfer molding method.

Further, if desired, the epoxy resin composition according to the present invention may also contain mold release agents such as natural waxes, synthetic waxes, metal salts of straight chain aliphatic acids, acid amides, esters or paraffins, flame retardants such as chlorinated paraffin, bromotoluene, hexabromobenzene, antimony trioxide or the like, colorants such as carbon black, silane coupling agents or other suitable additives.

In general, the epoxy resin composition according to the present invention can be prepared by mixing thoroughly the starting components at predetermined ratios, then further fusion mixing the resultant blend on a heated roll mill or mixing by means of a kneader to obtain easily an epoxy resin molding compound.

The resin encapsulation type semiconductor device according to the present invention can readily be prepared by encapsulating a semiconductor device using the above epoxy resin composition. As the most general method for encapsulation, there may be mentioned the low pressure transfer molding method, but encapsulation can also be effected by other methods such as injection molding, compression molding and cast molding. As special encapsulation methods, there may also be employed a method in which the semiconductor surface is coated with a solvent type or non-solvent type composition. Alternatively, local encapsulation such as so called junction coating may also be available. The epoxy resin composition is cured at the time of encapsulation to provide finally a resin encapsulation type semiconductor device encapsulated within a cured product of this composition. Curing may be effected by heating desirably at a temperature of 150°C or higher.

The semiconductor referred to in the present invention is not particularly limited but inclusive of the integrated circuits, large scale integrated circuits, transistors, thyristors and diodes.

According to the present invention, there can be provided a resin encapsulation type semiconductor device having excellent characteristics as well as reliability as mentioned in detail below.

First of all, the resin encapsulation type semiconductor device according to the present invention is excellent in humidity resistance and therefore markedly decreased in failures of aluminum wiring or electrodes in semiconductor device through corrosion or leak current failure due to moisture when used under hot and humid conditions. Moreover, reliability can be guaranteed for a long term.

Secondly, the resin encapsulation type semiconductor device according to the invention is also excellent in high temperature electrical characteristics. When used at a high temperature or under high temperature state brought about locally by generation of heat, leak current failure as well as electrical insulating failure cna significantly be decreased as compared with the prior art even in case of semiconductor devices having MOS structure of PN junction which is liable to generate leak current, whereby high reliability can be ensured for a long term.

The following Examples are set forth for illustration of the present invention as well as the advantages thereof. There are also shown epoxy resin encapsulation type semiconductor devices of prior art as Comparison examples, in order to clarify by way of comparison the excellent humidity resistance, electrical characteristics and reliability. But these Examples should not in any sense be construed as limitative of the present invention.

## Examples

There were prepared various epoxy resin encapsulation type semiconductor devices, which were provided for tests including pressure cooker test (PCT), bias-PCT, high temperature electrical characteristic tests or others for investigation about humidity resistance, high temperature electrical characteristics, etc. Unless otherwise noted, all of the epoxy resins employed contain a hydrolyzable chlorine of not higher than 0.1% by weight with a chlorine ion content of 10 ppm or less.

### Experiment 1

*Volume resistivity*

A composition comprising 100 parts by weight of a cresol novolac type epoxy resin with an epoxy equivalent of 220, 50 parts by weight of a phenol novolac resin having a molecular weight of 750 and a hydroxyl equivalent of 103, 1 part by weight of triphenylphosphine, 370 parts by weight of quartz glass powders, 3 parts by weight of carnauba wax and 2 parts by weight of carbon black was homogeneously mixed and thereafter kneaded on a heated roll mill. Then, after cooling, the resultant mass was pulverized to prepare an epoxy resin composition. This composition was molded at 170°C for 3 minutes, followed by curing at 170°C for 8 hours to obtain a molded product. Volume resistivity of this molded product was measured at 150°C to be $5 \times 10^{14}$ Ω·cm.

For comparative purpose, there was also prepared a composition (Comparative experiment 1), in which 2 parts by weight of 2-methylimidazole were used in place of the triphenylphosphine in the above composition, and volume resistivity thereof was measured at 150°C under the same conditions as mentioned above to be $4 \times 10^{12}$ Ω·cm.

### Experiment 2

*Leak current*

An epoxy resin composition was prepared by mixing 100 parts by weight of a phenol novolac type epoxy resin with an epoxy equivalent of 200, 50 parts by weight of a phenol novolac resin (curing agent) having a molecular weight of 700 with an epoxy equivalent of 103 and 0.03 parts by weight of triphenylphosphine (curing accelerator).

The above epoxy resin composition was cast molded into electrodes comprising copper plates with area of 1 $cm^2$ facing to each other with an interval of 1 mm, followed by curing by heating at 160°C for 5 hours. The thus resin encapsulated electrical parts, 20 in all, were heated at the temperatures indicated in Table 1, respectively, for one hour before measurement of the leak current between the electrodes by application of 100 V direct current therebetween in order to find out leak current failures. A leak current exceeding $1 \times 10^{-10}$A was judged to be failure.

For comparison, there was also prepared an epoxy resin composition (Comparative experiment 2), in which 0.12 parts by weight of 2-heptadecylimidazole were mixed in place of the triphenylphosphine in the above composition. Twenty electrical parts prepared by resin encapsulation similarly as described above using this composition were tested for leak current. All of the results are set forth together in Table 1.

TABLE 1

| | High temperature electrical characteristics (Total percentage of leak current failures (%)) | | | | |
|---|---|---|---|---|---|
| Sample | 30°C | 90°C | 120°C | 150°C | 180°C |
| Experiment 2 | 0 | 0 | 0 | 0 | 0 |
| Comparative experiment 2 | 0 | 10 | 75 | 100 | – |

Examples 1—5

There were prepared various compositions comprising the components selected from a cresol novolac type epoxy resin with an epoxy equivalent of 220 (Epoxy resin A), a bromine-containing epoxy novolac resin with an epoxy equivalent of 290 (Epoxy resin B), a curing agent of a phenol novolac resin having a molecular weight of 800 and a phenolic hydroxyl equivalent of 103, triphenylphosphine, 2-methylimidazole, quartz glass powders, carnauba wax, antimony trioxide, carbon black and a silane coupling agent ($\gamma$-glycidoxypropyltrimethoxysilane) at the ratios (parts by weight) indicated in Table 2. Each of these formulations was subjected to a series of processing steps including mixing with a mixer, kneading on a heated roll mill, pulverization after cooling, etc. to prepare a compound for transfer molding.

Using the thus prepared molding compounds, MOS integrated circuits were encapsulated therein by transfer molding to provide a DIP type (Dual-in-line package type) semiconductor device. Encapsulation was effected by molding the molding compound heated to 90°C by a high frequency pre-heater at 175°C for one minute, followed by heating at 180°C for 4 hours. The ratio of phenolic hydroxyl groups possessed by the novolac resin/epoxy groups possessed by the epoxy resin in each Examples is also shown in Table 2.

In each of Examples and Comparative examples, the following evaluation tests were conducted using 100 samples of the resin encapsulated semiconductor devices.

(1) Humidity resistance test(bias-PCT) was performed, by which failure of aluminum wiring through corrosion was examined by application of a voltage of 10 V in a water vapor at 120°C under 2 atm. The results are shown in Table 3.

TABLE 2

| Component | Example 1 | Example 2 | Example 3 | Example 4 | Example 5 | Comparative example 1 | Comparative example 2 |
|---|---|---|---|---|---|---|---|
| Epoxy resin A | 180 | 200 | 180 | 200 | 180 | 180 | 180 |
| ,, B | 20 | – | 20 | – | 20 | 20 | 20 |
| Phenol novolac resin | 76 | 85 | 61 | 134 | 100 | 76 | 100 |
| Triphenylphosphine | 5 | 5 | 5 | 5 | 5 | – | – |
| 2-Methylimidazole | – | – | – | – | – | 5 | 5 |
| Quartz glass powders | 645 | 665 | 610 | 780 | 700 | 645 | 700 |
| Carnauba wax | 4 | 4 | 4 | 4 | 4 | 4 | 4 |
| Antimony trioxide | 30 | 30 | 30 | 30 | 30 | 30 | 30 |
| Carbon black | 4 | 4 | 4 | 4 | 4 | 4 | 4 |
| Silane coupling agent | 4 | 4 | 4 | 4 | 4 | 4 | 4 |
| Ratio of hydroxyl groups to epoxy groups | 0.83 | 0.91 | 0.67 | 1.4 | 1.1 | 0.83 | 1.1 |

(2) A test for examination of failure occurrence through deterioration of electrical characteristics (BT test) was conducted by application of a voltage of 10 V between the source and the drain in the field region in an oven at 150°C. The results are shown in Table 4. The result with leak current of 1 $\mu$A or more is judged to be failure.

Example 6

A composition comprising 100 parts by weight of a cresol novolac type epoxy resin with an epoxy equivalent of 240, 45 parts by weight of a phenol novolac resin having a molecular weight of 750 and a hydroxyl equivalent of 103, 1 part by weight of triphenylphosphine, 350 parts by weight of quartz glass powders, 3 parts by weight of carnauba wax and 2 parts by weight of carbon black was thoroughly mixed and thereafter kneaded on a roll mill. Then, after cooling, the resultant mass was pulverized to prepare an epoxy resin molding compound.

For comparison, there was also prepared an epoxy resin molding compound (Comparative example 6a) having a composition similar to the above composition except that 4 parts by weight of 2-ethylimidazole were employed in place of the triphenylphosphine. Further, another epoxy resin molding compound for comparative purpose (Comparative example 6b) was also prepared, using a composition comprising 100 parts by weight of a bisphenol A type epoxy resin with an epoxy equivalent of 400, 30 parts by weight of hexahydrophthalic anhydride, 2 parts by weight of triphenylphosphine, 300 parts by weight of quartz glass powders, 5 parts by weight of carnauba wax and 2 parts by weight of carbon black, under otherwise the same conditions as mentioned above.

TABLE 3

| Sample \ Time | Bias-PCT Total failures (%) | | | | |
|---|---|---|---|---|---|
| | 20 Hr. | 50 Hr. | 100 Hr. | 200 Hr. | 300 Hr. |
| Example 1 | 0 | 0 | 0 | 0 | 0 |
| ,, 2 | 0 | 0 | 0 | 0 | 0 |
| ,, 3 | 0 | 0 | 0 | 0 | 2 |
| ,, 4 | 0 | 0 | 0 | 24 | 75 |
| ,, 5 | 0 | 0 | 0 | 3 | 42 |
| Comparative example 1 | 82 | 100 | – | – | – |
| ,, 2 | 79 | 100 | – | – | – |

TABLE 4

| Sample \ Time | BT test Total failures (%) 10 min. | 50 min. | 100 min. | 500 min. | 1000 min. |
|---|---|---|---|---|---|
| Example 1 | 0 | 0 | 0 | 0 | 0 |
| ,, 2 | 0 | 0 | 0 | 0 | 0 |
| ,, 3 | 0 | 0 | 0 | 0 | 4 |
| ,, 4 | 0 | 0 | 0 | 2 | 73 |
| ,, 5 | 0 | 0 | 0 | 0 | 50 |
| Comparative example 1 | 73 | 100 | – | – | – |
| ,, 2 | 71 | 100 | – | – | – |

Example 7

There was prepared an epoxy resin type composition by mixing 200 parts by weight of a phenol novolac type epoxy resin with an epoxy equivalent of 200, 20 parts by weight of a bromine-containing epoxy novolac resin, 100 parts by weight of a cresol novolac resin having a molecular weight of 800 and a hydroxyl equivalent of 117, 2 parts by weight of triphenylphosphine, 700 parts by weight of quartz glass powders, 5 parts by weight of carnauba wax, 50 parts by weight of antimony trioxide and 3 parts by weight of carbon black. The composition was treated in the same manner as in Example 6 to prepare an epoxy resin molding compound.

The above procedure was repeated except that the triphenylphosphine was replaced with 4 parts by weight of 2-heptadecylimidazole to prepare an epoxy resin molding compound (Comparative example 7), which is to be provided as a sample for comparative purpose.

Using the thus prepared molding compounds of Examples 6 and 7 and Comparative examples 6a, 6b and 7, MOS integrated circuit devices prepared for evaluation were transfer molded under the molding conditions of 175°C and 3 minutes, followed by curing at 180°C for 6 hours, to provide DIP type resin encapsulation type semiconductor devices. For each of the following tests, there were provided 100 resin encapsulation type semiconductor devices.

(1) Humidity resistance test (PCT), wherein the test sample was left to stand in a high temperature and high pressure water vapor at 120°C under 2 atm. The judgement of failure was conducted by detection of corrosion in aluminum wiring.

TABLE 5

| Sample \ Time | PCT Total failures (%) 250 Hr. | 500 Hr. | 750 Hr. | 1000 Hr. |
|---|---|---|---|---|
| Example 6 | 0 | 0 | 0 | 0 |
| ,, 7 | 0 | 0 | 0 | 0 |
| Comparative example 6a | 22 | 94 | 100 | – |
| ,, 6b | 72 | 100 | – | – |
| ,, 7 | 35 | 100 | – | – |

TABLE 6

| Sample \ Time | Bias-PCT Total failures (%) | | | |
|---|---|---|---|---|
| | 20 Hr. | 40 Hr. | 80 Hr. | 160 Hr. |
| Example 6 | 0 | 0 | 0 | 0 |
| ,, 7 | 0 | 0 | 0 | 0 |
| Comparative example 6a | 53 | 100 | – | – |
| ,, 6b | 0 | 42 | 100 | – |
| ,, 7 | 48 | 100 | – | – |

TABLE 7

| Sample \ Time | BT test Total failures (%) | | | |
|---|---|---|---|---|
| | 10 min. | 50 min. | 100 min. | 500 min. |
| Example 6 | 0 | 0 | 0 | 0 |
| ,, 7 | 0 | 0 | 0 | 0 |
| Comparative example 6a | 88 | 100 | – | – |
| ,, 6b | 0 | 20 | 100 | – |
| ,, 7 | 75 | 100 | – | – |

(2) Humidity resistance test(bias-PCT), wherein a voltage of 15 V was applied on a test sample in a high temperature and high pressure water vapor at 120°C under 2 atm. Failure judgement was conducted by detection of corrosion in aluminum wiring.

(3) Failure occurrence through deterioration of electrical characteristics at a high temperature was examined by application of a voltage of 10 V between the source and the drain in a hot oven at 150°C (BT test). A leak current detected of 1 $\mu$A or higher at the field region is judged to be failure. The results of each test are shown in Tables 5 to 7, respectively.

Example 8

A composition comprising 100 parts by weight of a cresol novolac type epoxy resin with an epoxy equivalent of 220, 40 parts by weight of a phenol novolac resin having a molecular weight of 700 and a hydroxyl equivalent of 103, 1 part by weight of 1,2-bis(diphenylphosphino)ethane, 400 parts by weight of crystalline silica powders, 2 parts by weight of carnauba wax, 2 parts by weight of calcium stearate and 2 parts by weight of carbon black was treated in the same manner as in Example 6 to prepare an epoxy resin molding compound.

There was also prepared an epoxy resin molding compound (Comparative example 8) according to the same procedure as described above, except that 2 parts by weight of benzyldimethylamine were used in place of the 1,2-bis(diphenylphosphino)ethane in the above composition.

Using the thus prepared molding compounds of Example 8 and Comparative example 8, transistor devices were prepared by low pressure transfer molding method under the molding conditions of 180°C and 2 minutes, followed by post curing at 170°C for 8 hours, to give resin encapsulation type transistor devices. For each of the following tests, one hundred encapsulation type transistor devices were provided.

(1) Table 8 shows the results of humidity test(bias-PCT), wherein a reverse bias of 30 V was applied between the base and the emitter in a water vapor at 120°C under 2 atm. Corrosion of aluminum wiring was judged to be failure.

(2) Table 9 shows the results of BT tests, wherein leak currents were measured while applying a reverse bias of 30 V between the base and the emitter in a hot oven at 150°C. A leak current of 1 μA or more is judged to be failure.

TABLE 8

| Sample \ Time | Bias-PCT Total failures (%) | | | |
|---|---|---|---|---|
| | 20 Hr. | 40 Hr. | 80 Hr. | 160 Hr. |
| Example 8 | 0 | 0 | 0 | 0 |
| Comparative example 8 | 39 | 95 | 100 | – |

TABLE 9

| Sample \ Time | BT test Total failures (%) | | | |
|---|---|---|---|---|
| | 20 min. | 50 min. | 100 min. | 500 min. |
| Example 8 | 0 | 0 | 0 | 0 |
| Comparative example 8 | 66 | 92 | 100 | – |

Example 9

An epoxy resin composition was prepared by mixing 100 parts by weight of a phenol novolac type epoxy resin with an epoxy equivalent of 175, 48 parts by weight of a phenol novolac resin having a molecular weight of 500 and a hydroxyl equivalent of 103 and 0.1 part by weight of triphenylphosphine.

In the above composition, the triphenylphosphine was replaced with 0.2 parts by weight of dimethylaminomethylphenol to repeat the procedure under otherwise the same conditions, whereby there was obtained another epoxy resin composition (Comparative example 9).

The thus prepared epoxy resin compositions of Example 9 and Comparative example 9 were employed for cast molding of integrated circuit devices, followed by curing at 170°C for 5 hours, to obtain resin encapsulation type integrated circuit devices, of which 100 samples were provided for use in each of the following tests.

(1) Bias-PCT test was performed by applying a bias voltage of 15 V in a water vapor at 120°C under 2 atm. Corrosion occurred in aluminum wiring was judged to be failure.

(2) BT test was performed by application of a bias voltage of 15 V in a hot oven at 150°C. A leak current of 1 μA or more was judged to be failure. The results are shown in Tables 10 and 11, respectively.

TABLE 10

| Sample \ Time | Bias-PCT Total failures (%) | | | |
|---|---|---|---|---|
| | 20 Hr. | 40 Hr. | 80 Hr. | 160 Hr. |
| Example 9 | 0 | 0 | 0 | 0 |
| Comparative example 9 | 57 | 100 | – | – |

TABLE 11

| Sample \ Time | BT test Total failures (%) | | | |
|---|---|---|---|---|
| | 10 min. | 50 min. | 100 min. | 500 min. |
| Example 9 | 0 | 0 | 0 | 0 |
| Comparative example 9 | 70 | 100 | – | – |

To the epoxy resin compositions of Example 9 and Comparative example 9, there were added organic solvents to lower their viscosities until solutions thereof were obtained, respectively. By use of these solutions, coatings were applied on the surface of the integrated circuit devices. After evaporation of the solvent, followed by curing under heating at 180°C for 5 hours, there were obtained semiconductor devices coated with resins. One hundred samples for each example were subjected to the BT test wherein a bias voltage of 15 V was applied in a hot oven at 150°C to give the results as shown in Table 12. A leak current between the source and the drain at the field region of 1 μA or more was judged to be failure.

TABLE 12

| Sample \ Time | BT test Total failures (%) | | | |
|---|---|---|---|---|
| | 10 min. | 50 min. | 100 min. | 500 min. |
| Example 9 | 0 | 0 | 0 | 0 |
| Comparative example 9 | 68 | 100 | – | – |

Example 10

In 100 parts by weight of methyl isobutyl ketone, there were dissolved 100 parts by weight of a cresol novolac type epoxy resin(epoxy equivalent: 230), 50 parts by weight of a phenol novolac resin (curing agent) having a molecular weight of 800 and a hydroxyl equivalent of 103, and 0.3 part by weight of diphenylphosphine as curing accelerator. The thus prepared solution was coated on the surface of an MOS integrated circuit device. After evaporation of methyl isobutyl ketone, the coated epoxy resin composition was cured by heating at 160°C for 6 hours. Between the source and the drain in the field region in the resin encapsulation type MOS integrated circuit device thus obtained, a voltage of 15 V was applied and the device was placed in an oven at 150°C. A leak current reaching 1 μA was judged to be failure, and such failure occurrences with lapse of time was measured as a percentage based on 50 test samples (BT test).

On the other hand, for comparative purpose, the above procedure was repeated except that there was employed a composition (Comparative example 10) in which 0.3 part by weight of the diphenylphosphine curing accelerator in the above composition was replaced with 0.8 part by weight of 2-ethylimidazole. Measurement of leak current was conducted similarly to determine the failures percentage based on 50 test samples.

These results are shown in Table 13.

TABLE 13

| Sample \ Time | BT test (Total failures (%)) | | | | |
|---|---|---|---|---|---|
| | 5 min. | 10 min. | 50 min. | 100 min. | 500 min. |
| Example 10 | 0 | 0 | 0 | 2 | 6 |
| Comparative example 10 | 22 | 98 | 100 | – | – |

Example 11

A mixture, comprising 100 parts by weight of a phenol novolac type epoxy resin(epoxy equivalent: 175), 50 parts by weight of a phenol novolac resin (curing agent) having a molecular weight of 700 and a hydroxyl equivalent of 103 and 0.5 part by weight of diphenylphosphine as curing accelerator, was employed for cast molding of a transistor having an aluminum wiring, followed by curing at 180°C for 5 hours to prepare a resin encapsulation type transistor device. While applying a reverse bias voltage of 10 V between emitter and base, the device was placed in a hot and pressurized water vapor at 120°C under 2 atm. Occurrence of failure in aluminum wiring through corrosion was examined with lapse of time for 50 test samples (Bias-PCT).

For comparison, Example 11 was repeated except that 1.0 part by weight of dimethylaminomethylphenol was used in place of 0.5 part by weight of diphenylphosphine curing accelerator (Comparative example 11). These results are shown in Table 14.

TABLE 14

| Sample \ Time | Bias-PCT Total failures (%) | | | | |
|---|---|---|---|---|---|
| | 10 Hr. | 30 Hr. | 60 Hr. | 100 Hr. | 150 Hr. |
| Example 11 | 0 | 0 | 0 | 2 | 12 |
| Comparative example 11 | 26 | 72 | 100 | – | – |

Example 12

A composition comprising 100 parts by weight of a cresol novolac type epoxy resin with an epoxy equivalent of 220, 50 parts by weight of a phenol novolac resin having a molecular weight of 800 and a hydroxyl equivalent of 103, 4 parts by weight of diphenylphosphine, 350 parts by weight of quartz glass powders, 2 parts by weight of carnauba wax and 2 parts by weight of carbon black was homogeneously mixed and thereafter kneaded on a roll mill. Then, after cooling, the resultant mass was pulverized to prepare a molding compound.

Example 13

An epoxy resin molding compound was prepared similarly as in Example 12 by using a composition comprising 170 parts by weight of a cresol novolac type epoxy resin with an epoxy equivalent of 240, 20 parts by weight of a bromine-containing epoxy novolac resin with an epoxy equivalent of 290, 80 parts by weight of a phenol novolac resin having a molecular weight of 750 and a hydroxyl equivalent of 103, 700 parts by weight of quartz glass powders, 5 parts by weight of bis(phenylphosphino)ethane, 5 parts by weight of carnauba wax, 50 parts by weight of antimony trioxide, 3 parts by weight of carbon black and 3 parts by weight of a silane coupling agent.

Example 14

Similarly as in Example 12, an epoxy resin molding compound was prepared using a composition comprising 100 parts by weight of a phenol novolac type epoxy resin with an epoxy equivalent of 200, 45 parts by weight of a cresol novolac resin having a molecular weight of 800 and a hydroxyl equivalent of 117, 6 parts by weight of hexadecylphosphine, 400 parts by weight of crystalline silica powders, 5 parts by weight of zinc stearate and 2 parts by weight of carbon black.

Comparative example 12

A homogeneous mixture comprising 100 parts by weight of a cresol novolac type epoxy resin with an epoxy equivalent of 220, 50 parts by weight of a phenol novolac resin having a molecular weight of 800 with a hydroxyl equivalent of 103, 4 parts by weight of 2-heptadecylimidazole, 350 parts by weight of quartz glass powders, 2 parts by weight of carnauba wax and 2 parts by weight of carbon black was kneaded on a roll mill and then pulverized after being cooled to prepare an epoxy resin molding compound.

Comparative example 13

An epoxy resin molding compound was prepared similarly as in Comparative example 12 by using a composition comprising 170 parts by weight of a cresol novolac type epoxy resin with an epoxy equivalent of 240, 20 parts by weight of a bromine-containing epoxy novolac resin with an epoxy equivalent of 290, 80 parts by weight of a phenol novolac resin having a molecular weight of 750 and a hydroxyl equivalent of 103, 700 parts by weight of quartz glass powders, 5 parts by weight of 2-phenylimidazole, 5 parts by weight of carnauba wax, 50 parts by weight of antimony trioxide, 3 parts by weight of carbon black and 3 parts by weight of a silane coupling agent ($\gamma$-glycidoxypropyltrimethoxysilane).

Comparative example 14

According to the same procedure as in Comparative example 12, there was prepared an epoxy resin molding compound using 100 parts by weight of a phenol novolac type epoxy resin with an epoxy equivalent of 200, 45 parts by weight of a cresol novolac resin having a molecular weight of 800 and a hydroxyl equivalent of 117, 3 parts by weight of 2-methylimidazole, 400 parts by weight of crystalline silica powders, 5 parts by weight of zinc stearate and 2 parts by weight of carbon black.

Comparative example 14a

According to the same procedure as in Comparative example 12, an epoxy resin molding compound was prepared by use of a composition comprising 100 parts by weight of a bisphenol A type epoxy resin with an epoxy equivalent of 400, 30 parts by weight of tetrahydrophthalic anhydride, 3 parts by weight of diphenylphosphine, 350 parts by weight of crystalline silica powders, 5 parts by weight of carnauba wax and 2 parts by weight of carbon black.

Using the epoxy resin molding compounds of Example 12 and Comparative example 12 as mentioned above, there were molded electrical insulating plates of 3 mm in thickness under the molding conditions of 190°C and 10 minutes. After postcuring at 180°C for 4 hours, the above electrical insulating plates were found to have a volume resistivity of $4 \times 10^{14}$ Ω·cm for the sample of Example 12 and $2 \times 10^{12}$ Ω·cm for the sample of Comparative example 12.

Using the molding compounds obtained in the above Examples 12 to 14 and Comparative examples 12 to 14a, encapsulation of integrated circuits was effected under the molding conditions of 190°C and 10 minutes, followed by post-curing at 180°C for 7 hours. For the thus prepared resin encapsulated DIP-type semiconductor devices, bias-PCT was performed by application of a voltage of 10 V in a hot and pressurized water vapor at 120°C under 2 atm. The results of evaluation of reliability by the time at which failure took place in aluminum wiring through corrosion were listed in Table 15, in which the numerals indicate the percentages of failures based on 100 samples.

TABLE 15

| Sample \ Time | Bias-PCT Total failures (%) | | | |
|---|---|---|---|---|
| | 20 Hr. | 40 Hr. | 80 Hr. | 160 Hr. |
| Example 12 | 0 | 0 | 0 | 3 |
| ,, 13 | 0 | 0 | 2 | 5 |
| ,, 14 | 0 | 2 | 10 | 18 |
| Comparative example 12 | 42 | 100 | – | – |
| ,, 13 | 48 | 100 | – | – |
| ,, 14 | 53 | 100 | – | – |
| ,, 14a | 8 | 65 | 100 | – |

Example 15

A homogeneous mixture, comprising 100 parts by weight of a cresol novolac type epoxy resin with an epoxy equivalent of 230, 50 parts by weight of a phenol novolac resin having a molecular weight of 700 and a hydroxyl equivalent of 103, 2 parts by weight of triphenylphosphine, 5 parts by weight of methylphenylpolysiloxane having silanolic hydroxyl groups (M.W. = 1600; hydroxyl equivalent = 400; produced by Toray Silicon Co. Ltd., trade name: SH 6018), 360 parts by weight of quartz glass powders, 2 parts by weight of carnauba wax and 2 parts by weight of carbon black, was kneaded on a roll mill and, after being cooled, pulverized to prepare an epoxy resin molding compound.

Moldability of the above epoxy resin molding compound was examined by transfer molding method to obtain the results as set forth in Table 16. As to the molding conditions, the molding compound heated to 80°C by a high frequency pre-heater was subjected to transfer molding at 170°C for 2 minutes.

Using the above epoxy resin molding compound, MOS integrated circuit devices were molded by transfer molding method under the conditions of 170°C and 2 minutes, followed further by post-curing under heating at 180°C for 4 hours, thus providing DIP-type semiconductor devices. The thus prepared resin encapsulation type integrated circuit devices were subjected to humidity test (Bias-PCT) by application of a voltage of 10 V in a hot and pressurized water vapor at 120°C under 2 atom. for evaluation of reliability by the time at which failure took place in aluminum wiring through corrosion. The results are shown in Table 17, in which the numerals are total failures percentage based on 100 test samples.

For comparison, an epoxy resin molding compound was also prepared similarly as in Example 15 from a composition comprising 100 parts by weight of a cresol novolac type epoxy resin with an epoxy equivalent 230, 50 parts by weight of a phenol novolac resin having a molecular weight of 700 and a hydroxyl equivalent of 103, 4 parts by weight of 2-ethylimidazole, 360 parts by weight of quartz glass powders, 2 parts by weight of carbauba wax and 2 parts by weight of carbon black (Comparative example 15).

Using the above epoxy resin molding compound, transfer molding thereof was conducted similarly as in Example 15 for examination of moldability and at the same time resin encapsulation type integrated circuit devices were prepared under the same conditions as in Example 15. The humidity test (bias-PCT) was also performed under the same conditions as in Example 15. These results are also shown in Tables 16 and 17.

TABLE 16

| Sample | Moldability | | | | |
|---|---|---|---|---|---|
| | Burr | Mold release | Appearance of product | Mold contamination | Mark characteristics |
| Example 15 | o | o | o | o | o |
| Comparative example 15 | x | Δ | x | x | x |

Note) o: good, Δ: slightly bad, x: bad

TABLE 17

| Time / Sample | Bias-PCT Total failures (%) | | | |
|---|---|---|---|---|
| | 20 Hr. | 40 Hr. | 80 Hr. | 160 Hr. |
| Example 15 | 0 | 0 | 0 | 0 |
| Comparative example 15 | 58 | 100 | – | – |

Example 16

There was prepared an epoxy molding compound having a composition comprising 100 parts by weight of a phenol novolac type epoxy resin with an epoxy equivalent of 210, 50 parts by weight of a cresol novolac resin having a molecular weight of 800 and a hydroxyl equivalent of 117, 2 parts by weight of 1,2-bis(diphenylphosphino)ethane, 2 parts by weight of methylphenylpolysiloxane having silanol groups (SH 6018), 400 parts by weight of crystalline silica powders, 2 parts by weight of carnauba wax and 2 parts by weight of carbon black.

For comparison, there was also prepared a composition (Comparative example 16) comprising 100 parts by weight of a phenol novolac type epoxy resin with an epoxy equivalent of 210, 50 parts by weight of a cresol novolac resin having a molecular weight of 800 and a hydroxyl equivalent of 117, 4 parts by weight of 2-phenylimidazole, 400 parts by weight of crystalline silica powders, 2 parts by weight of carnauba wax and 2 parts by weight of carbon black.

Using the respective epoxy resin molding compound of the above Example 16 and Comparative example 16, MOS integrated circuit devices were encapsulated therein similarly as in Example 15, respectively, to give DIP-type semiconductor devices. For 100 samples of each of these devices, bias-PCT was conducted under the same conditions as in Example 15 for evaluation of reliability to obtain the results as shown in Table 18.

TABLE 18

| Time / Sample | Bias-PCT Total failures (%) | | | |
|---|---|---|---|---|
| | 20 Hr. | 40 Hr. | 80 Hr. | 160 Hr. |
| Example 16 | 0 | 0 | 0 | 0 |
| Comparative example 16 | 61 | 100 | – | – |

Using the epoxy resin molding compounds of the above Example 16 and Comparative example 16, respectively, electrical insulating plates with thickness of 3 mm were molded under the conditions of 180°C and 3 minutes. The above electrical insulating plates, after being further cured at 180°C for 5 hours, were found to have volume resistivities, measured at 150°C, of $5 \times 10^{14}$ Ω·cm for Example 16 and of $2 \times 10^{12}$ Ω·cm for Comparative example 16.

Example 17

According to the same procedure as in Example 15, there was prepared an epoxy resin molding material by mixing 100 parts by weight of a cresol novolac type epoxy resin with an epoxy equivalent of 230, 10 parts by weight of a bromine-containing epoxy novolac resin with an epoxy equivalent of 290, 50 parts by weight of a phenol novolac resin having a molecular weight of 700 and a hydroxyl equivalent of 103, 1 part by weight of triphenylphosphine, 1 part by weight of methylphenylpolysiloxane having silanolic hydroxyl groups (SH 6018), 350 parts by weight of quartz glass powders, 2 parts by weight of carnauba wax, 2 parts by weight of carbon black, 20 parts by weight of antimony trioxide and 2 parts by weight of a silane coupling agent ($\gamma$-glycidoxypropyltrimethoxysilane).

For comparison, there was also prepared an epoxy resin molding compound (Comparative example 17) similarly as in Example 15 which was composed of 100 parts by weight of a bisphenol A type epoxy resin with an epoxy equivalent of 400, 30 parts by weight of tetrahydrophthalic anhydride, 3

parts by weight of triphenylphosphine, 350 parts by weight of quartz glass powders, 6 parts by weight of carnauba wax and 2 parts by weight of carbon black.

Further, as another Comparative example, there was also prepared an epoxy resin molding compound (Comparative example 17a) in the same manner as in Example 15 which was composed of 100 parts by weight of a cresol novolac type epoxy resin with an epoxy equivalent of 230, 40 parts by weight of diaminodiphenylsulfone as curing agent, 4 parts by weight of dimethylaminomethylphenol as curing accelerator, 10 parts by weight of methylphenylpolysiloxane having silanolic hydroxyl groups (SH 6018), 350 parts by weight of quartz glass powders, 4 parts by weight of carnauba wax and 2 parts by weight of carbon black.

Using the epoxy resin molding compounds of the above Example 17, Comparative examples 17 and 17a, respectively, MOS integrated circuit devices were encapsulated therein to provide DIP-type semiconductor devices. One hundred test samples for each compound were provided for use in bias-PCT conducted similarly as in Example 15 to give the results as shown in Table 19.

TABLE 19

| Time / Sample | Bias—PCT Total failures (%) | | | |
|---|---|---|---|---|
| | 20 Hr. | 40 Hr: | 80 Hr. | 160 Hr. |
| Example 17 | 0 | 0 | 0 | 0 |
| Comparative example 17 | 0 | 37 | 100 | — |
| ,, 17a | 20 | 93 | 100 | — |

Examples 18—20

Eight kinds of various epoxy resin molding compounds, including Comparative examples, were prepared at various proportions (parts by weight) indicated in Table 20 of the components chosen from a phenol novolac type epoxy resin with an epoxy equivalent of 200 (Epoxy resin C), a bisphenol A type epoxy resin with an epoxy equivalent of 400 (Epoxy resin D), a phenol novolac resin having a molecular weight of 700 and a hydroxyl equivalent of 103, methyl nadic anhydride, triphenylphosphine, tris(acetylacetonato)aluminum, bis(dimethylglyoxymato)nickel, (ethylenediaminetetraacetato)cobalt and dimethylbenzylamine.

Using the above epoxy resin compositions, MOS integrated circuit devices were cast molded therein, followed by curing at 170°C for 8 hours, to provide resin encapsulation type semiconductor devices. Using 50 test samples of these encapsulation type semiconductor devices for each composition, the following tests were conducted:

(1) Humidity resistance test (PCT), wherein the test sample was left to stand in a high temperature and high pressure water vapor at 120°C under 2 atm., was conducted to give the results as shown in Table 21. The judgement of failure was conducted by detection of corrosion in aluminum wiring.

(2) Humidity resistance test(bias-PCT), wherein a voltage of 10 V was applied on a test sample in a high temperature and high pressure water vapor at 120°C under 2 atm., was conducted to give the results as shown in Table 22.

(3) Failure occurrence through deterioration of electrical characteristics at high temperatures was examined by application of a voltage of 10 V between the source and the drain in a hot oven at 150°C (BT test). The results of each test are shown in Table 23. A leak current detected of 1 μA or higher at the field region is judged to be failure.

TABLE 20

| Component | Example | | | Comparative example | | | | |
|---|---|---|---|---|---|---|---|---|
| | 18 | 19 | 20 | 18 | 19 | 20 | 20a | 20b |
| Epoxy resin C | 100 | 100 | 100 | 100 | 100 | – | 100 | 100 |
| ,, D | – | – | – | – | – | 100 | – | – |
| Phenol resin | 50 | 50 | 50 | 50 | – | – | 50 | 50 |
| Acid anhydride | – | – | – | – | 80 | 40 | – | – |
| Triphenylphosphine | 0.1 | 0.1 | 0.1 | – | – | 0.1 | 0.1 | – |
| Tris(acetylacetonato)-aluminum | 0.05 | – | – | – | – | – | 5 | 0.05 |
| Bis(dimethylglyoximato)-nickel | – | 0.05 | – | – | – | – | – | – |
| (Ethylenediaminetetra-acetato)cobalt | – | – | 0.05 | – | 0.05 | – | – | – |
| Dimethylbenzylamine | – | – | – | 0.1 | 0.1 | – | – | – |

TABLE 21

| Sample \ Time | PCT Total failures (%) | | | |
|---|---|---|---|---|
| | 150 Hr. | 300 Hr. | 450 Hr. | 600 Hr. |
| Example 18 | 0 | 0 | 0 | 0 |
| ,, 19 | 0 | 0 | 0 | 0 |
| ,, 20 | 0 | 0 | 0 | 0 |
| Comparative example 18 | 22 | 56 | 100 | – |
| ,, 19 | 64 | 100 | – | – |
| ,, 20 | 56 | 100 | – | – |
| ,, 20a | 12 | 26 | 100 | – |
| ,, 20b | 26 | 48 | 100 | – |

TABLE 22

| Sample \ Time | Bias–PCT Total failures (%) | | | |
|---|---|---|---|---|
| | 20 Hr. | 40 Hr. | 80 Hr. | 160 Hr. |
| Example 18 | 0 | 0 | 0 | 0 |
| ,, 19 | 0 | 0 | 0 | 0 |
| ,, 20 | 0 | 0 | 0 | 0 |
| Comparative example 18 | 66 | 100 | – | – |
| ,, 19 | 54 | 100 | – | – |
| ,, 20 | 20 | 88 | 100 | – |
| ,, 20a | 30 | 64 | 100 | – |
| ,, 20b | 34 | 92 | 100 | – |

TABLE 23

| Sample \ Time | BT test Total failures (%) | | | |
|---|---|---|---|---|
| | 10 min. | 50 min. | 100 min. | 500 min. |
| Example 18 | 0 | 0 | 0 | 0 |
| ,, 19 | 0 | 0 | 0 | 0 |
| ,, 20 | 0 | 0 | 0 | 0 |
| Comparative example 18 | 92 | 100 | - | - |
| ,, 19 | 80 | 100 | - | - |
| ,, 20 | 30 | 60 | 100 | - |
| ,, 20a | 28 | 56 | 100 | - |
| ,, 20b | 36 | 74 | 100 | - |

Examples 21—23

There were prepared 8 kinds of various epoxy resin molding compounds, including Comparative examples, at various proportions (parts by weight) indicated in Table 24 of the components chosen from a cresol novolac type epoxy resin with an epoxy equivalent of 220 (Epoxy resin E), an alicyclic epoxy resin with an epoxy equivalent of 370 (Epoxy resin F), a bromine-containing epoxy novolac resin (Epoxy resin G), a phenol novolac resin curing agent having a molecular weight of 800 and a hydroxyl equivalent of 103, tetrahydrophthalic anhydride, triphenylphosphine, tetrakis (acetylacetonato)zirconium, diglycinatopalladium, disalicylaldehydecopper, 2-phenylimidazole, quartz glass powders, carnauba wax, antimony trioxide, carbon black and a silane coupling agent ($\gamma$-glycidoxypropyltrimethoxysilane). Each of the above compositions was prepared by kneading the components selected together on a heated roll mill and pulverizing the cooled mass to provide an epoxy resin type molding compound.

Using the thus prepared molding compounds, MOS integrated circuit devices were encapsulated therein by transfer molding to obtain DIP-type semiconductor devices. Molding was carried out by subjecting a molding compound pre-heated to 80°C by a high frequency pre-heater to molding at 175°C for 3 minutes, followed by post-curing at 180°C for 7 hours. For 100 test samples of resin encapsulated MOS integrated circuit devices of each example, PCT, bias-PCT and BT tests were conducted, respectively, under the same conditions as in Examples 18—20 to obtain the results as shown in Tables 25, 26 and 27.

TABLE 24

| Component | Example | | | Comparative example | | | | |
|---|---|---|---|---|---|---|---|---|
| | 21 | 22 | 23 | 21 | 22 | 23 | 23a | 23b |
| Epoxy resin E | 180 | 180 | 195 | 180 | 180 | – | 180 | 180 |
| ,, F | – | – | – | – | – | 210 | – | – |
| ,, G | 20 | 20 | – | 20 | 20 | – | 20 | 20 |
| Phenol resin | 90 | 90 | 90 | 90 | 90 | – | 90 | 90 |
| Acid anhydride | – | – | – | – | – | 70 | – | – |
| Triphenylphosphine | 3 | 3 | 3 | – | – | 3 | 3 | – |
| Tetrakis(acetylacetonato)zirconium | 1 | – | – | – | 1 | – | – | 4 |
| Diglycinatopalladium | – | 1 | – | – | – | – | 9 | – |
| Disalicylaldehydecopper | – | – | 1 | – | – | – | – | – |
| 2-Phenylimidazole | – | – | – | 3 | 3 | – | – | – |
| Quartz glass powders | 700 | 700 | 700 | 700 | 700 | 700 | 700 | 700 |
| Carbauba wax | 4 | 4 | 4 | 4 | 4 | 4 | 4 | 4 |
| Antimony trioxide | 30 | 30 | – | 30 | 30 | – | 30 | 30 |
| Carbon black | 4 | 4 | 4 | 4 | 4 | 4 | 4 | 4 |
| Silane coupling agent | 4 | 4 | 4 | 4 | 4 | 4 | 4 | 4 |

TABLE 25

| Sample \ Time | PCT Total failures (%) | | | |
|---|---|---|---|---|
| | 250 Hr. | 500 Hr. | 750 Hr. | 1000 Hr. |
| Example 21 | 0 | 0 | 0 | 0 |
| ,, 22 | 0 | 0 | 0 | 0 |
| ,, 23 | 0 | 0 | 0 | 0 |
| Comparative example 21 | 18 | 63 | 100 | – |
| ,, 22 | 66 | 100 | – | – |
| ,, 23 | 62 | 100 | – | – |
| ,, 23a | 0 | 24 | 72 | 100 |
| ,, 23b | 0 | 42 | 86 | 100 |

TABLE 26

| Sample \ Time | Bias–PCT Total failures (%) | | | |
|---|---|---|---|---|
| | 20 Hr. | 40 Hr. | 80 Hr. | 160 Hr. |
| Example 21 | 0 | 0 | 0 | 0 |
| ,, 22 | 0 | 0 | 0 | 0 |
| ,, 23 | 0 | 0 | 0 | 0 |
| Comparative example 21 | 53 | 100 | – | – |
| ,, 22 | 32 | 100 | – | – |
| ,, 23 | 12 | 100 | – | – |
| ,, 23a | 0 | 33 | 100 | – |
| ,, 23b | 0 | 68 | 100 | – |

TABLE 27

| Sample \ Time | BT test Total failures (%) | | | |
|---|---|---|---|---|
| | 10 min. | 50 min. | 100 min. | 500 min. |
| Example 21 | 0 | 0 | 0 | 0 |
| ,, 22 | 0 | 0 | 0 | 0 |
| ,, 23 | 0 | 0 | 0 | 0 |
| Comparative example 21 | 86 | 100 | – | – |
| ,, 22 | 75 | 100 | – | – |
| ,, 23 | 45 | 100 | – | – |
| ,, 23a | 0 | 59 | 100 | – |
| ,, 23b | 21 | 80 | 100 | – |

Examples 24—26

There were prepared three kinds of epoxy resin compositions containing the components at indicated proportions (parts by weight) in Table 28 chosen from the materials as used in Examples 21—23 and tris(acetylacetonato)aluminum. According to the same treatment as in Examples 21—23, they were converted to molding compounds and MOS integrated circuit devices were encapsulated therein under the same conditions as in said Examples to provide DIP-type semiconductor devices. PCT was conducted for 100 test samples of the encapsulated devices of each example under the conditions of 120°C and 2 atm. The results are shown in Table 29.

TABLE 28

| Component | Example 24 | Example 25 | Example 26 |
|---|---|---|---|
| Epoxy resin E | 180 | 180 | 180 |
| ,, G | 20 | 20 | 20 |
| Phenol novolac resin | 100 | 100 | 100 |
| Triphenylphosphine | 5 | 5 | 5 |
| Tris(acetylacetonato) aluminum | 1 | – | – |
| Diglycinatopalladium | – | 1 | – |
| Quartz glass powders | 700 | 700 | 700 |
| Carnauba wax | 4 | 4 | 4 |
| Antimony trioxide | 30 | 30 | 30 |
| Carbon black | 4 | 4 | 4 |
| Silane coupling agent | 4 | 4 | 4 |

TABLE 29

| Sample \ Time | PCT Total failures (%) | | | |
|---|---|---|---|---|
| | 500 Hr. | 1000 Hr. | 1500 Hr. | 2000 Hr. |
| Example 24 | 0 | 0 | 0 | 1 |
| ,, 25 | 0 | 0 | 0 | 3 |
| ,, 26 | 0 | 0 | 14 | 72 |

Examples 27—29

Eight kinds of various epoxy resin molding compounds, including Comparative examples, were prepared at various proportions (parts by weight) indicated in Table 30 of the components chosen from a phenol novolac type epoxy resin with an epoxy equivalent of 200 (Epoxy resin H), a phenol novolac resin curing agent having a molecular weight of 700 and a hydroxyl equivalent of 103, methyl nadic anhydride, triphenylphosphine, tris(acetylacetonato)aluminum, bis(dimethylglyoximato)nickel, (ethylenediaminetetraacetato)cobalt, methylphenylpolysiloxane having silanolic hydroxyl groups (SH 6018) and dimethylbenzylamine.

Using the above epoxy resin compositions, MOS integrated circuit devices were cast molded therein, followed by curing at 170°C for 8 hours, to provide resin encapsulated type semiconductor devices. Using 50 test samples of these encapsulation type semiconductor devices for each composition, the following tests were conducted:

(1) Humidity resistance test (bias-PCT) for examination of failure in aluminum wiring through corrosion, wherein a voltage of 10 V was applied on a test sample in a high temperature and high pressure water vapor at 120°C under 2 atm., was conducted to give the results as shown in Table 31.

(2) Failure occurrence through deterioration of electrical characteristics at high temperatures was examined by application of a voltage of 10 V between the source and the drain in a hot oven at 150°C (BT test). The results of each test are shown in Table 32. A leak current detected of 1 $\mu$A or higher at the field region is judged to be failure.

TABLE 30

| Component | Example | | | Comparative example | | | | |
|---|---|---|---|---|---|---|---|---|
| | 27 | 28 | 29 | 27 | 28 | 29 | 29a | 29b |
| Epoxy resin H | 100 | 100 | 100 | 100 | 100 | 100 | 100 | 100 |
| Phenol resin | 50 | 50 | 50 | 50 | – | 50 | 50 | 50 |
| Acid anhydride | – | – | – | – | 80 | – | – | – |
| Triphenylphosphine | 0.1 | 0.1 | 0.1 | – | – | – | – | – |
| Tris(acetylacetonato)-aluminum | 0.05 | – | – | – | – | – | – | 0.05 |
| Bis(dimethylglyoximato)-nickel | – | 0.05 | – | – | – | – | 0.05 | – |
| Ethylenediamine-tetraacetatocobalt | – | – | 0.05 | – | 0.05 | – | – | – |
| ≡Si–OH containing silicone | 1 | 1 | 1 | – | – | 10 | 20 | – |
| Dimethylbenzylamine | – | – | – | 0.1 | 0.1 | 0.1 | 0.1 | – |

TABLE 31

| Time / Sample | Bias–PCT Total failures (%) | | | |
|---|---|---|---|---|
| | 20 Hr. | 40 Hr. | 80 Hr. | 160 Hr. |
| Example 27 | 0 | 0 | 0 | 0 |
| ,, 28 | 0 | 0 | 0 | 0 |
| ,, 29 | 0 | 0 | 0 | 0 |
| Comparative example 27 | 66 | 100 | – | – |
| ,, 28 | 54 | 100 | – | – |
| ,, 29 | 24 | 100 | – | – |
| ,, 29a | 36 | 100 | – | – |
| ,, 29b | 34 | 92 | 100 | – |

TABLE 32

| Time / Sample | BT test Total failures (%) | | | |
|---|---|---|---|---|
| | 10 min. | 50 min. | 100 min. | 500 min. |
| Example 27 | 0 | 0 | 0 | 0 |
| ,, 28 | 0 | 0 | 0 | 0 |
| ,, 29 | 0 | 0 | 0 | 0 |
| Comparative example 27 | 92 | 100 | – | – |
| ,, 28 | 80 | 100 | – | – |
| ,, 29 | 40 | 94 | 100 | – |
| ,, 29a | 32 | 90 | 100 | – |
| ,, 29b | 36 | 74 | 100 | – |

Examples 30—32

There were prepared 7 kinds of various epoxy resin compositions, including Comparative examples, at various proportions (parts by weight) indicated in Table 33 of the components chosed from a cresol novolac type epoxy resin with an epoxy equivalent of 220 (Epoxy resin I), an alicyclic epoxy resin with an epoxy equivalent of 370 (Epoxy resin J), a bromine-containing epoxy novolac resin (Epoxy resin K), a phenol novolac resin curing agent having a molecular weight of 800 and a hydroxyl equivalent of 103, tetrahydrophthalic anhydride, triphenylphosphine, tris(acetylacetonato)aluminum, diglycinatopalladium, disalicylaldehydecopper, methylphenylpolysiloxane having silanolic hydroxyl groups (SH 6018), 2-phenylimidazole, quartz glass powders, carnauba wax, antimony trioxide, carbon black and a silane coupling agent ($\gamma$-glycidoxypropyltrimethoxysilane). Each of the above compositions was prepared by kneading the components selected together on a heated roll mill and pulverizing the cooled mass to provide an epoxy resin type molding compound.

Using the thus prepared molding compounds, MOS integrated circuit devices were encapsulated therein by transfer molding method to obtain DIP-type semiconductor devices. Encapsulation was carried out by subjecting a molding compound pre-heated to 80°C by a high frequency pre-heater to molding at 175°C for 3 minutes, followed by post-curing at 180°C for 7 hours. For 100 test samples of resin encapsulated MOS integrated circuit devices of each example, bias-PCT and BT tests were conducted, respectively, under the same conditions as in Examples 27—29 to obtain the results as shown in Tables 34 and 35.

TABLE 33

| Component | Example | | | Comparative example | | | |
|---|---|---|---|---|---|---|---|
| | 30 | 31 | 32 | 30 | 31 | 32 | 32a |
| Epoxy resin I | 180 | 180 | 195 | 180 | 180 | – | – |
| ,, J | – | – | – | – | – | 210 | 210 |
| ,, K | 20 | 20 | – | 20 | 20 | – | – |
| Phenol resin | 90 | 90 | 90 | 90 | – | 90 | 90 |
| Acid anhydride | – | – | – | – | 70 | – | – |
| Triphenylphosphine | 5 | 5 | 5 | – | – | – | – |
| Tris(acetylacetonato)aluminum | 1 | – | – | – | – | – | 1 |
| Diglycinatopalladium | – | 1 | – | – | 1 | – | – |
| Disalicylaldehydecopper | – | – | 1 | – | – | – | – |
| (≡Si–OH)-containing Silicone | 6 | 6 | 6 | – | – | 17 | 40 |
| 2-Phenylimidazole | – | – | – | 5 | 5 | 5 | – |
| Quartz glass powders | 700 | 700 | 700 | 700 | 700 | 700 | 700 |
| Carnauba wax | 4 | 4 | 4 | 4 | 4 | 4 | 4 |
| Antimony trioxide | 30 | 30 | – | 30 | 30 | – | – |
| Carbon black | 4 | 4 | 4 | 4 | 4 | 4 | 4 |
| Silane coupling agent | 4 | 4 | 4 | 4 | 4 | 4 | 4 |

TABLE 34

| Sample \ Time | Bias–PCT Total failures (%) | | | |
|---|---|---|---|---|
| | 20 Hr. | 40 Hr. | 80 Hr. | 160 Hr. |
| Example 30 | 0 | 0 | 0 | 0 |
| ,, 31 | 0 | 0 | 0 | 0 |
| ,, 32 | 0 | 0 | 0 | 0 |
| Comparative example 30 | 80 | 100 | – | – |
| ,, 31 | 40 | 100 | – | – |
| ,, 32 | 34 | 90 | 100 | – |
| ,, 32a | 24 | 52 | 100 | – |

TABLE 35

| Sample \ Time | BT test Total failures (%) | | | |
|---|---|---|---|---|
| | 10 min. | 50 min. | 100 min. | 500 min. |
| Example 30 | 0 | 0 | 0 | 0 |
| ,, 31 | 0 | 0 | 0 | 0 |
| ,, 32 | 0 | 0 | 0 | 0 |
| Comparative example 30 | 91 | 100 | – | – |
| ,, 31 | 77 | 100 | – | – |
| ,, 32 | 55 | 100 | – | – |
| ,, 32a | 22 | 94 | 100 | – |

Moldability of the above transfer molded resin encapsulation type semiconductor devices was examined for Example 30 and Comparative example 32 to obtain the results as shown in Table 36.

TABLE 36

| Sample | Moldability | | | | |
|---|---|---|---|---|---|
| | Burr | Mold release | Appearance of product | Mold contamination | Mark characteristics |
| Example 30 | o | o | o | o | o |
| Comparative example 32 | x | Δ | x | x | x |

Note) o: good, Δ: slightly bad, x: bad

Examples 33—36

There were prepared 4 kinds of compositions from the same materials as used in Examples 30 to 32 at proportions indicated in Table 37, from which molding compounds were also prepared.

Using these molding compounds, MOS integrated circuit devices were encapsulated therein to prepare DIP-type semiconductor devices. Bias-PCT test and BT test were conducted for these examples. Encapsulation and the tests were conducted under the same conditions as in Examples 30—32. The results are shown in Table 38 and Table 39. The epoxy resin molding compound used in Example 36 was the same as used in Example 5 and contained neither metal chelate nor organic silicon compound.

TABLE 37

| Component | Example 33 | 34 | 35 | 36 |
|---|---|---|---|---|
| Epoxy resin I | 180 | 180 | 180 | 180 |
| ,, K | 20 | 20 | 20 | 20 |
| Phenol resin | 100 | 100 | 100 | 100 |
| Triphenylphosphine | 5 | 5 | 5 | 5 |
| Tris(acetylacetonato)-aluminum | 1 | – | – | – |
| Disalicylaldehydecopper | – | 1 | – | – |
| (≡Si–OH) –containing silicone | 6 | 6 | 6 | – |
| Quartz glass powders | 700 | 700 | 700 | 700 |
| Carnauba wax | 4 | 4 | 4 | 4 |
| Antimony trioxide | 30 | 30 | 30 | 30 |
| Silane coupling agent | 4 | 4 | 4 | 4 |
| Carbon black | 4 | 4 | 4 | 4 |

TABLE 38

| Sample \ Time | Bias–PCT Total failures (%) 150 Hr. | 200 Hr. | 300 Hr. | 500 Hr. | 700 Hr. |
|---|---|---|---|---|---|
| Example 33 | 0 | 0 | 0 | 0 | 1 |
| ,, 34 | 0 | 0 | 0 | 0 | 3 |
| ,, 35 | 0 | 0 | 0 | 2 | 25 |
| ,, 36 | 0 | 3 | 42 | 100 | – |

TABLE 39

| Sample \ Time | BT test Total failures (%) | | | |
|---|---|---|---|---|
| | 500 min. | 1000 min. | 2000 min. | 3000 min. |
| Example 33 | 0 | 0 | 0 | 4 |
| ,, 34 | 0 | 0 | 0 | 7 |
| ,, 35 | 0 | 0 | 8 | 32 |
| ,, 36 | 0 | 50 | 100 | - |

## Claims

1. A semiconductor device encapsulated within a cured epoxy resin composition, containing an epoxy resin and a novolac resin, characterized in that the novolac resin contains phenolic hydroxyl groups at a ratio of about 0.5 to about 1.5 relative to the epoxy groups possessed by said epoxy resin, and that the composition contains 0.001 to 20 parts by weight of an organic phosphine compound per 100 parts by weight of the resin component consisting of said epoxy resin and said novolac resin.

2. A device according to Claim 1, wherein the epoxy resin composition further contains an inorganic filler.

3. A device according to Claim 2, wherein the inorganic filler is silica powders and/or quartz glass powders.

4. A device according to Claim 1 or Claim 2, wherein the epoxy resin is a novolac type epoxy resin with an epoxy equivalent of 170 to 300.

5. A device according to Claim 1 or Claim 2, wherein the novolac resin is contained in an amount so that the ratio of the phenolic hydroxyl groups possessed by the novolac resin to the epoxy groups possessed by the epoxy resin may be 0.5 or more and less than 1.

6. A device according to Claim 5, wherein the ratio of the phenolic hydroxyl groups possessed by novolac resin to the epoxy groups possessed by the epoxy resin is in the range from 0.77 to 0.95.

7. A device according to Claim 1 or Claim 2, wherein the organic phosphine compound is a triarylphosphine or a bis (diarylphosphine)alkane, of which alkane moiety has 1 to 20 carbon atoms.

8. A device according to Claim 1 or Claim 2, wherein the epoxy resin is a novolac type epoxy resin with an epoxy equivalent of 170 to 300, the organic phosphine compound is a triarylphosphine or a bis(diarylphosphino)alkane, of which alkane moiety has 1 to 20 carbon atoms.

9. A device according to Claim 1 or Claim 2, wherein the epoxy resin is a novolac type epoxy resin with an epoxy equivalent of 170 to 300, the organic phosphine compound is a triarylphosphine or a bis(diarylphosphino)alkane, of which alkane moiety has 1 to 20 carbon atoms, and the novolac resin is contained in an amount so that the ratio of the phenolic hydroxyl groups possessed by the novolac resin to the epoxy groups possessed by the epoxy resin may be 0.5 or more and less than 1.

10. A device according to Claim 1 or Claim 2, wherein the epoxy resin composition further contains an organic silicon compound having silanolic hydroxyl groups in an amount of 0.05 to 10 parts by weight per 100 parts by weight of the resin component consisting of the epoxy resin and the novolac resin.

11. A device according to Claim 1 or Claim 2, wherein the organic phosphine compound contained in the epoxy resin composition is 0.01 to 20 parts by weight per 100 parts by weight of the resin component consisting of the epoxy resin and the novolac resin, and said epoxy resin composition further contains a metal chelate compound in an amount of 1 to 100 parts by weight per 100 parts by weight of said organic phosphine compound.

12. A device according to Claim 11, wherein the metal chelate compound is a chelate compound of at least one metal selected from the group consisting of aluminum, cobalt, chromium, copper, iron, manganese, nickel, palladium, rhodium, titanium, vanadium, zinc, and zirconium.

13. A device according to Claim 1 or Claim 2, wherein the epoxy resin composition comprises a novolac type epoxy resin with an epoxy equivalent of 170 to 300, a novolac resin containing phenolic hydroxyl groups at a ratio of about 0.5 to about 1.5 relative to the epoxy groups possessed by said epoxy resin, a triarylphosphine an an amount of 0.01 to 20 parts by weight per 100 parts by weight of the resin component consisting of said epoxy resin and said novolac resin, an organic silicon compound having silanolic hydroxyl groups in an amount of 0.05 to 10 parts by weight per 100 parts by weight of

said resin component, and a chelate compound of a metal selected from the group consisting of aluminum, cobalt, chromium, copper, iron, manganese, nickel, palladium, rhodium, titanium, vanadium, zinc and zirconium in an amount of 1 to 100 parts by weight per 100 parts by weight of said triarylphosphine.

**Patentansprüche**

1. Halbleiterbauelement, welches in einer gehärteten Epoxyharzzusammensetzung eingekapselt ist, wobei diese Zusammensetzung ein Epoxyharz und ein Novolackharz enthält, dadurch gekennzeichnet, daß das Novolackharz phenolische Hydroxylgruppen in einem Verhältnis von ca. 0,5 bis ca. 1,5 in bezug auf die Epoxygruppen, welche das genannte Epoxyharz aufweist, enthält, und daß die Zusammensetzung 0,001 bis 20 Gewichtsteile einer organischen Phosphinverbindung pro 100 Gewichtsteile der Harzkomponente, bestehende aus dem genannten Epoxyharz und dem genannten Novolackharz, enthält.

2. Bauelement gemäß Anspruch 1, dadurch gekennzeichnet, daß die Epoxyharzzusammensetzung im weiteren einen anorganischen Füllstoff enthält.

3. Bauelement gemäß Anspruch 2, dadurch gekennzeichnet, daß der anorganische Füllstoff Siliciumdioxidpulver und/oder Quarzglaspulver darstellt.

4. Bauelement gemäß Anspruch 1 oder 2, dadurch gekennzeichnet, daß das Epoxyharz ein Epoxyharz vom Novolacktyp mit einem Epoxyäquivalent von 170 bis 300 darstellt.

5. Bauelement gemäß Anspruch 1 oder 2, dadurch gekennzeichnet, daß das Novolackharz in einer Menge enthalten ist, daß das Verhältnis der phenolischen Hydroxylgruppen, welche das Novolackharz aufweist, zu den Epoxygruppen, welche das Epoxyharz aufweist, 0,5 oder mehr und weniger als 1 sein kann.

6. Bauelement gemäß Anspruch 5, dadurch gekennzeichnet, daß das Verhältnis der phenolischen Hydroxylgruppen, welche das Novolackharz aufweist, zu den Epoxygruppen, welche das Epoxyharz aufweist, im Bereich von 0,77 bis 0.95 ist.

7. Bauelement gemäß Anspruch 1 oder 2, dadurch gekennzeichnet, daß die organische Phosphinverbindung ein Triarylphosphin oder ein Bis(diarylphosphino)alkan ist, wobei die Alkankomponente 1 bis 20 Kohlenstoffatome aufweist.

8. Bauelement gemäß Anspruch 1 oder 2, dadurch gekennzeichnet, daß das Epoxyharz ein Epoxyharz vom Novolacktyp mit einem Epoxyäquivalent von 170 bis 300 ist, die organische Phosphinverbindung ein Triarylphosphin oder ein Bis(diarylphosphino)alkan ist, wobei die Alkankomponente 1 bis 20 Kohlenstoffatome aufweist.

9. Bauelement gemäß Anspruch 1 oder 2, dadurch gekennzeichnet, daß das Epoxyharz ein Epoxyharz vom Novolacktyp mit einem Epoxyäquivalent von 170 bis 300 ist, die organische Phosphinverbindung ein Triarylphosphin oder Bis(diarylphosphino)alkan ist, wobei die Alkankomponente 1 bis 20 Kohlenstoffatome aufweist, und das Novolackharz in einer Menge enthalten ist, daß das Verhältnis der phenolischen Hydroxylgruppen, welche das Novolackharz aufweist, zu den Epoxygruppen, welche das Epoxyharz aufweist, 0,5 oder mehr und weniger als 1 sein kann.

10. Bauelement gemäß Anspruch 1 oder 2, dadurch gekennzeichnet, daß die Epoxyharzzusammensetzung im weiteren eine organische Siliciumverbindung mit silanolischen Hydroxylgruppen in einer Menge von 0,05 bis 10 Gewichtsteilen pro 100 Gewichtsteile der Harzkomponente, bestehend aus Epoxyharz und Novolackharz, enthält.

11. Bauelement gemäß Anspruch 1 oder 2, dadurch gekennzeichnet, daß die organische Phosphinverbindung, welche in der Epoxyharzzusammensetzung enthalten ist, 0,01 bis 20 Gewichtsteile pro 100 Gewichtsteile der Harzkomponente, bestehend aus dem Epoxyharz und dem Novolackharz, ausmacht, und die genannte Epoxyharzzusammensetzung im weiteren eine Metallchelatverbindung in einer Menge von 1 bis 100 Gewichtsteilen pro 100 Gewichtsteile der genannten organischen Phosphinverbindung enthält.

12. Bauelement gemäß Anspruch 11, dadurch gekennzeichnet, daß die Metallchelatverbindung eine Chelatverbindung von mindestens einem Metall aus der Gruppe Aluminium, Kobalt, Chrom, Kupfer, Eisen, Mangan, Nickel, Palladium, Rhodium, Titan, Vanadium, Zink und Zirkon darstellt.

13. Bauelement gemäß Anspruch 1 oder 2, dadurch gekennzeichnet, daß die Epoxyharzzusammensetzung ein Epoxyharz vom Novolacktyp mit einem Epoxyäquivalent von 170 bis 300, ein Novolackharz, welches phenolische Hydroxylgruppen in einem Verhältnis von ca. 0,5 bis ca. 1,5 in bezug auf die Epoxygruppen, welche das genannte Epoxyharz aufweist, ein Triarylphosphin in einer Menge von 0,01 bis 20 Gewichtsteilen pro 100 Gewichtsteile der Harzkomponente, bestehend aus dem genannten Epoxyharz und dem genannten Novolackharz, eine organische Siliciumverbindung mit silanolischen Hydroxylgruppen in einer Menge von 0,05 bis 10 Gewichtsteilen pro 100 Gewichtsteile der genannten Harzkomponente, und eine Chelatverbindung eines Metalles, ausgewählt aus der Gruppe Aluminium, Kobalt, Chrom, Kupfer, Eisen, Mangan, Nickel, Palladium, Rhodium, Titan, Vanadium, Zink und Zirkon in einer Menge von 1 bis 100 Gewichtsteilen pro 100 Gewichtsteile des ganannten Triarylphosphins, umfaßt.

**Revendications**

1. Dispositif semi-conducteur enrobé dans une composition de résine époxy durcie contenant une résine époxy et une résine novolac, caractérisé par le fait que la résine novolac contient des groupes hydroxyle phénoliques à raison d'environ 0,5 à environ 1,5 par rapport aux groupes époxy possédés par ladite résine époxy, et que la composition contient 0,01 à 20 parties en poids d'un composé de phosphine organique pour 100 parties en poids du composant résineux constitué par ladite résine époxy et ladite résine novolac.

2. Dispositif selon la revendication 1, dans lequel la composition de résine époxy contient en outre une charge minérale.

3. Dispositif selon la revendication 2, dans lequel la charge minérale est de la silice en poudre et/ou de la poudre de verre de quartz.

4. Dispositif selon la revendication 1 ou la revendication 2, dans lequel la résine époxy est une résine époxy du type novolac ayant un équivalent époxy de 170 à 300.

5. Dispositif selon la revendication 1 ou la revendication 2, dans lequel la résine novolac est contenue en une quantité telle que le rapport des groupes hydroxyle phénoliques possédés par la résine novolac aux groupes époxy possédés par la résine époxy peut être 0,5 ou davantage et inférieur à 1.

6. Dispositif selon la revendication 5, dans lequel le rapport des groupes hydroxyle phénoliques possédés par la résine novolac aux groupes époxy possédés par la résine époxy est compris entre 0,77 et 0,95.

7. Dispositif selon la revendication 1 ou la revendication 2, dans lequel le composé de phosphine organique est une triarylphosphine ou un bis(diarylphosphino)alcane dont le motif alcane a 1 à 20 atomes de carbone.

8. Dispositif selon la revendication 1 ou la revendication 2, dans lequel la résine époxy est une résine époxy du type novolac ayant un équivalent époxy de 170 à 300, le composé de phosphine organique est une triarylphosphine ou un bis(diarylphosphino)alcane dont le motif alcane a 1 à 20 atomes de carbone.

9. Dispositif selon la revendication 1 ou la revendication 2, dans lequel la résine époxy est une résine époxy du type novolac ayant un équivalent époxy de 170 à 300, le composé de phosphine organique est une triarylphosphine ou un bis(diarylphosphino)alcane dont le motif alcane a 1 à 20 atomes de carbone et la résine novolac est contenue en une quantité telle que le rapport des groupes hydroxyle phénoliques possédés par la résine novolac aux groupes époxy possédés par la résine époxy peut être de 0,5 ou davantage et inférieur à 1.

10. Dispositif selon la revendication 1 ou la revendication 2, dans lequel la composition de résine époxy contient encore un composé organique du silicium comportant des groupes hydroxyle silanoliques, en une quantité de 0,05 à 10 parties en poids, pour 100 parties en poids du composant résineux constitué par la résine époxy et la résine novolac.

11. Dispositif selon la revendication 1 ou selon la revendication 2, dans lequel le composé de phosphine organique est contenu dans la composition de résine époxy à raison de 0,01 à 20 parties en poids, pour 100 parties en poids du composant résineux constitué par la résine époxy et la résine novolac, et ladite composition de résine époxy contient encore un composé chélate métallique à raison de 1 à 100 parties en poids, pour 100 parties en poids dudit composé de phosphine organique.

12. Dispositif selon la revendication 11, dans lequel le composé chélate métallique est un composé chélate d'au moins un métal choisi parmi le groupe constitué par l'aluminium, le cobalt, le chrome, le cuivre, le fer, le manganèse, le nickel, le palladium, le rhodium, le titane, le vanadium, le zinc et le zirconium.

13. Dispositif selon la revendication 1 ou selon la revendication 2, dans lequel la composition de résine époxy comprend une résine époxy du type novolac ayant un équivalent époxy de 170 à 300, une résine novolac contenant des groupes hydroxyle phénoliques dans un rapport d'environ 0,5 à environ 1,5 par rapport aux groupes époxy possédés par ladite résine époxy, une triarylphosphine à raison de 0,01 à 20 parties en poids, pour 100 parties en poids du composant résineux constitué par ladite résine époxy et ladite résine novolac, un composé organique du silicium ayant des groupes hydroxyle silanoliques, en une quantité de 0,05 à 10 parties en poids, pour 100 parties en poids dudit composant résineux, et un composé chélate d'un métal choisi parmi le groupe constitué par l'aluminium, le cobalt le chrome, le cuivre, le fer, le manganèse, le nickel, le palladium, le rhodium, le titane, le vanadium, le zinc et le zirconium, à raison de 1 à 100 parties en poids, pour 100 parties en poids de ladite triarylphosphine.